# EUROPÄISCHE PATENTANMELDUNG

(11) **EP 1 235 102 A2**
(43) Veröffentlichungstag der Anmeldung: **28.08.2002**
(21) Anmeldenummer: 01128208.4
(22) Anmeldetag: 28.11.2001
(51) Int. Cl.: G03F 1/00, G03F 7/20

(54) **Verfahren und Mehrstrahl-Abtastvorrichtung zur Ablation durch Lasergravur für die Herstellung von Flexo-Druckplatten**

(30) Priorität: 24.02.2001 DE 10109041
(71) Anmelder: Heidelberger Druckmaschinen Aktiengesellschaft, 69115 Heidelberg (DE)
(72) Erfinder: Fischer, Jörg-Achim, 24235 Laboe (DE); Gebhardt, Axel, 24248 Mönkeberg (DE); Jacobsen, Thomas, 24111 Kiel (DE); Ressel, Peter, 24232 Schönkirchen (DE); Steinke, Dirk, 24247 Mielkendorf (DE)

(57) **Zusammenfassung**

Die Erfindung betrifft ein Verfahren und eine Mehrstrahl-Abtastvorrichtung (6) zur Ablation von Film oder Druckplatten, insbesondere zur Ablation von Flexo-Druckplatten (3) auf der Oberfläche einer rotierenden Trommel (2) durch Lasergravur mit einem Multi-Spot-Array, wobei aus einer Mehrzahl von nebeneinander angeordneten Laser-Fiberexits (19), insbesondere YAG-Laser-Fiberexits, gleichzeitig eine Mehrzahl von Laserstrahlenbündeln (14) emittiert wird, wobei die Laserstrahlenbündel (14) nach ihrem Austritt aus den Fiberexits (19) in einem AOM-Array (20) mit einer der Anzahl der Fiberexits (19) entsprechenden Anzahl von AOMs (21) jeweils in zwei oder mehr Teilstrahlenbündel (14a, 14b) aufgeteilt und die Teilstrahlenbündel (14a, 14b) unabhängig voneinander moduliert werden, wobei die Fiberexits (19) durch ein Optiksystem (22) auf dem Film oder der Druckplatte (3) abgebildet werden, und wobei die Fiberexits (19), das AOM-Array (20) und das Optiksystem (21) gemeinsam in axialer Richtung (P) der Trommel (2) in Bezug zu dieser bewegt werden, während der Film oder die Druckplatte (3) in Umfangsrichtung (R) der Trommel (2) mit dem Multi-Spot-Array abgetastet wird, um es ohne eine Vergrößerung der Anzahl der Fiberlaser (7) zu ermöglichen, die Anzahl der Abtastpunkte (15) des Multi-Spot-Arrays zu vergrößern und den Platzbedarf der Abtastvorrichtung (6) zu verkleinern.

## Beschreibung

Die Erfindung bezieht sich auf das Gebiet der elektronischen Reproduktionstechnik, besonders auf die Herstellung von Film oder Druckplatten und insbesondere Flexo-Druckplatten. Die Erfindung betrifft dabei speziell ein Verfahren und eine Mehrstrahl-Abtastvorrichtung zur Ablation von Film oder Druckplatten und insbesondere Flexo-Druckplatten durch Lasergravur mit einem Multi-Spot-Array, wobei diese auf die Umfangsfläche einer Trommel aufgespannt und mit einer Mehrzahl von Laserstrahlenbündeln abgetastet werden.

Flexo-Druckplatten zur Laserdirektbelichtung oder Lasergravur bestehen gewöhnlich aus einer unteren Trägerschicht aus Polyester oder einem anderen biegsamen Kunststoffmaterial, einer mittleren sogenannten Photopolymerschicht, enthaltend ungesättigte Monomere und elastomere Bindemittel, die bei einer Belichtung mit UV-Licht vernetzt werden und dadurch eine spätere Auswaschung beim Entwickeln verhindern, sowie einer oberen lasersensitiven Schicht, die durch die Lasergravur entsprechend den zu übertragenden Informationen in vorgegebenen Bereichen partiell entfernt wird, um über der Photopolymerschicht eine integral mit der Druckplatte verbundene Maske zu erzeugen. Diese Maske deckt bei einer anschließenden UV-Belichtung der Druckplatte diejenigen Bereiche der Photopolymerschicht ab, an denen die lasersensitive Schicht zuvor nicht entfernt worden ist und verhindert in diesen Bereichen die Vernetzung bzw. Aushärtung der Photopolymerschicht, so dass sie bei einer nachfolgenden Entwicklung der Druckplatte dort vom Entwickler ausgewaschen wird. Die fertig entwickelte Druckplatte weist erhabene und vertiefte Bereiche auf, wobei die ersteren dort angeordnet sind, wo die lasersensitive Schicht zuvor durch die Bestrahlung mit dem Laserlicht entfernt worden ist.

Grundsätzlich ist es jedoch auch denkbar, die erhabenen und vertieften Bereiche der Flexo-Druckplatte in Zukunft statt durch eine partielle Abtragung einer Maske und eine anschließende UV-Belichtung und Auswaschung der Druckplatte dadurch zu erzeugen, dass eine aus einem lasersensitiven Material hergestellte Druckplatte durch Bestrahlung mit Laserlicht in einem Schritt selektiv abgetragen wird. In diesem Fall würde mit dem zur Ablation verwendeten Laserlicht an Stelle einer negativen Abbildung der zu übertragenden Informationen auf der Maske eine positive Abbildung dieser Informationen auf der Druckplatte selbst erzeugt.

Bei den augenblicklich verwendeten Flexo-Druckplatten erfolgt die Lasergravur in einem Laserbelichter, in dem die Druckplatte auf die Oberfläche einer rotierenden Trommel aufgespannt und mit einem oder mehreren intensitätsmodulierten Laserstrahlenbündeln abgetastet wird, um die lasersensitive Schicht in den späteren Druckbereichen der Druckplatte entsprechend dem vorgegebenen Raster punktförmig abzutragen. Wie beispielsweise in der noch unveröffentlichten Deutschen Patentanmeldung DE 100 24 456.4 der Anmelderin beschrieben ist, umfassen die in axialer Richtung der Trommel beweglichen Laserbearbeitungsköpfe der Laserbelichter gewöhnlich eine Reihe von Fiberlasern zur gleichzeitigen Erzeugung einer Mehrzahl von Laserstrahlenbündeln, einen vor dem Fiberexit jedes Fiberlasers angeordneten optischen Schalter zur Modulation des austretenden Laserstrahlenbündels durch Unterbrechung bzw. Durchlass der Laserstrahlung entsprechend den jeweiligen Pixeldaten einer zu übertragenden Bildinformation, sowie ein Optiksystem zur Abbildung der Fiberexits als Multi-Spot-Array auf dem zu bearbeitenden Material.

Eine Möglichkeit zur Steigerung der Bearbeitungsgeschwindigkeit des Laserbelichters besteht darin, die Anzahl der Abtastpunkte des Multi-Spot-Arrays zu vergrößern. Dazu wird jedoch eine größere Anzahl von Fiberlasern benötigt, was wegen der verhältnismäßig hohen Kosten dieser Komponenten nach Möglichkeit vermieden werden sollte.

In einem Zeitschriftenartikel von B.M. Rosenheck, "180 mega-pixel per second optical image recording" in SPIE Vol. 299, Advances in Laser Scanning Technology (1981) ist bereits ein optisches System zur Bildaufzeichnung beschrieben, bei dem vier zuvor durch Strahlteiler getrennte, aus einem einzelnen Laser stammende Laserstrahlenbündel jeweils durch einen AOM gelenkt werden, bei dem an jedem AOM vier verschiedene Frequenzen angelegt werden, um die Laserstrahlenbündel in vier Teilstrahlenbündel aufzuspalten, und bei dem die Teilstrahlenbündel anschließend über einen rotierenden Polygonspiegel auf die Oberfläche einer rotierenden Trommel gelenkt werden, um die Trommeloberfläche im Wesentlichen gleichzeitig an 16 Abtastpunkten abzutasten. Ein solches System eignet sich jedoch nicht für die Lasergravur, da dort erheblich höhere Laserleistungen erforderlich sind. Außerdem weist ein solches System einen verhältnismäßig großen Platzbedarf auf, der es für eine industrielle Nutzung als Laserbelichter ungeeignet macht.

Ausgehend hiervon liegt der Erfindung die Aufgabe zugrunde, ein Verfahren und eine Mehrstrahl-Abtastvorrichtung der eingangs genannten Art zu entwickeln, die ohne eine Vergrößerung der Anzahl der Fiberlaser eine Erhöhung der Anzahl der Abtastpunkte des Multi-Spot-Arrays ermöglichen und mit einem geringen Platzbedarf realisierbar sind.

Diese Aufgabe wird erfindungsgemäß durch die in den Patentansprüchen 1 und 10 angegebenen Merkmalskombinationen gelöst. Bevorzugte Ausgestaltungen der Erfindung finden sich in den untergeordneten Patenansprüchen 2 bis 9 und 11 bis 19.

Eine bevorzugte Ausgestaltung der Erfindung sieht vor, dass die Teilstrahlenbündel in einer zur Strahlrichtung senkrechten Ebene ein zweidimensionales Multi-Spot-Array erzeugen, das aus den vorzugsweise zeilen- und spaltenweise überund nebeneinander angeordneten Auftreffpunkten der Laserstrahlenbündel besteht, und dass diese zur Erzielung von Linienanschluss durch eine entsprechende Zeitverzögerung und Ablenkung der einzelnen Teilstrahlenbündel diese gleichzeitig auf der rotierenden Trommel auftreffen und diese Auftreffpunkte in gleichen Abständen nebeneinander auf einer Geraden liegen, die parallel zur Richtung einer axialen Relativbewegung zwischen der Trommel und dem Laserbearbeitungskopf ist.

Zur Aufteilung der Laserstrahlenbündel in zwei oder mehr Teilstrahlenbündel werden an jedem AOM eine Anzahl von Spannungssignalen mit unterschiedlicher Frequenz angelegt, deren Anzahl der Anzahl der gewünschten Teilstrahlenbündel entspricht und deren Frequenzen innerhalb einer Bandbreite des AOMs liegen, in der ein ausreichender akustooptischer Wirkungsgrad gewährleistet ist. Die Spannungssignale werden vorzugsweise zeitversetzt am AOM angelegt werden, so dass die erzeugten Teilstrahlenbündel gleichzeitig in axialer Richtung der Trommel nebeneinander auf der Flexo-Druckplatte auftreffen.

Zur Verkürzung der Baulänge der Mehrstrahl-Abtastvorrichtung sind die YAG-Laser-Fiberexits vorzugsweise fächerförmig konvergierend ausgerichtet, wobei sich jeweils ein Teil der Teilstrahlenbündel in der Nähe einer Eintrittspupille des Optiksystems schneidet, das die Teilstrahlenbündel anschließend im Wesentlichen parallel ausrichtet und auf die Flexo-Druckplatte lenkt, wobei es für eine Im Wesentlichen telezentrische Abbildung der Fiberexits auf der Druckplatte sorgt. Das Optiksystem umfasst vorzugsweise zwei Linsen L1 und L2, die einen Beamexpander bilden, mit dem die Strahldurchmesser der Teilstrahlenbündel im Verhältnis der Brennweiten f2/f1 der beiden Linsen L1 und L2 aufgeweitet und ihr Winkelabstand im Verhältnis der Brennweiten f1/f2 verringert wird, bevor sie mit einer hinter den Linsen L1 und L2 angeordneten Linse L3 auf der Druckplatte fokussiert werden.

Da sich Fall das Abstands-/Durchmesserverhältnis der Auftreffpunkte der Teilstrahlenbündel auf der Druckplatte nicht beliebig verkleinern lässt, u.a. weil die Montage der Fiberexits in einer Halterung gewisse Mindest-Winkelabstände erforderlich macht, und weil die Brennweite des Optiksystems zur Verkürzung der Baulänge nicht zu groß gewählt werden kann, sieht eine weitere bevorzugte Ausgestaltung der Erfindung vor, dass der Laserbearbeitungskopf in Bezug zur Trommel um die optische Achse des Optiksystems gekippt wird, um anschließend durch eine entsprechende Verzögerung der Teilstrahlenbündel Linienanschluss zu erzielen.

Im folgenden wird die Erfindung anhand eines in der Zeichnung dargestellten Ausführungsbeispiels näher erläutert: Es zeigen:
- **Fig. 1:**: eine perspektivische Ansicht einer erfindungsgemäßen Vorrichtung zur Ablation von Flexo-Druckpatten auf einer rotierenden Trommel durch Lasergravur mit einem Multi-Spot-Array;
- **Fig. 2:**: eine schematische Ansicht des Strahlengangs von mehreren Laserstrahlenbündeln zwischen ihrem Austritt aus Fiberlasern eines Mehrstrahl- Laserbearbeitungskopfs der Vorrichtung aus Fig. 1 und einer Flexo-Druckplatte;
- **Fig. 3:**: eine schematische Ansicht eines Teils des Strahlengangs im Bereich eines AOM-Arrays Laserbearbeitungskopfs aus Fig. 2 bei Betrachtung in Richtung der Pfeile III-III in Fig. 2;
- **Fig. 4:**: eine perspektivische Ansicht eines zur Modulation und Aufteilung der Laserstrahlenbündel in mehrere Teilstrahlen verwendeten linearen AOM-Arrays;
- **Fig. 5:**: eine vergrößerte Ansicht des Strahlengangs in der Nähe eines Fiberexits eines Fiberlasers des Laserbearbeitungskopfs;
- **Fig. 6:**: eine Ansicht eines zweidimensionalen Multi-Spot-Arrays der Auftreffpunkte der Laserstrahlenbündel auf der Flexo-Druckplatte ohne eine Relativbewegung zwischen Laserbearbeitungskopf und Flexo-Druckplatte sowie die Lichtintensitätsverteilung an den Auftreffpunkten;
- **Fig. 7:**: eine Ansicht entsprechend Fig. 6, jedoch nach einem Kippen des Laserbearbeitungskopfs zur Erzielung von Linienanschluss und ohne die Lichtintensitätsverteilungen aus Fig. 6.

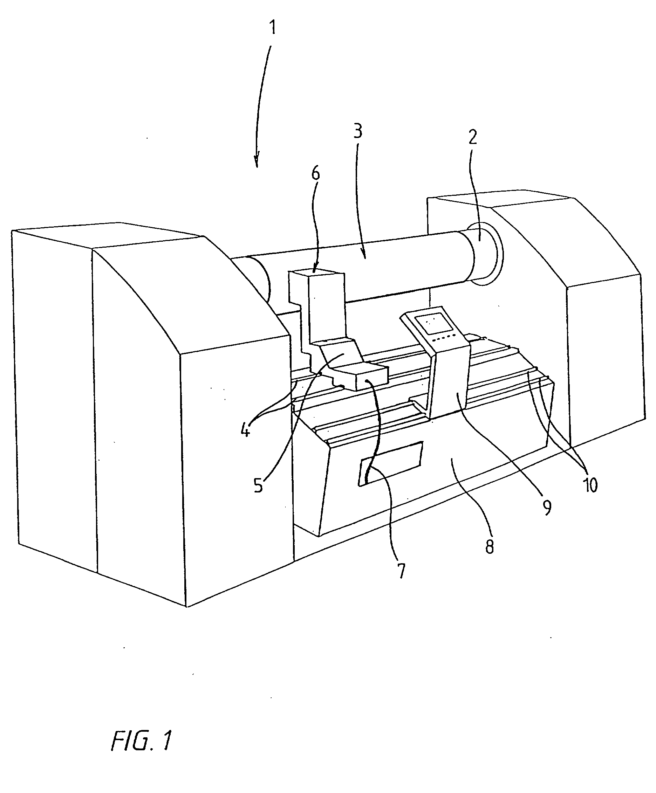

Die in Fig. 1 dargestellte Vorrichtung (1) zur Lasergravur von Flexo-Druckplatten besteht im Wesentlichen aus einer zwischen zwei seitlichen Halterungen drehbar eingespannten Trommel (2), auf deren Umfangsfläche die zu bearbeitenden Flexo-Druckplatten (3) aufgespannt werden, einem Drehantrieb (nicht dargestellt) zum Drehen der Trommel (2) und einer darauf aufgespannten Druckplatte (3), einem auf Führungen (4) in axialer Richtung der Trommel (2) und der Druckplatte (3) verfahrbaren Schlitten (5), einem drehbar auf dem Schlitten (5) montierten Laserbearbeitungskopf (6), der durch ein Bündel von acht Faserlichtleitern (7) mit einem Mehrstrahl-YAG-Laser (nicht sichtbar) in einem stationären Unterteil (8) der Vorrichtung (1) verbunden ist, sowie einem Steuerpult (9), das ebenfalls auf Führungen (10) in axialer Richtung entlang der Trommel (2) beweglich ist.
Der Mehrstrahl-YAG-Laser erzeugt acht Laserstrahlen, die nach dem Hindurchtritt durch einen der Faserlichtleiter (7) jeweils einzeln gebündelt werden, bevor die dabei erzeugten Laserstrahlenbündel (14) in jeweils zwei Teilstrahlenbündel (14a, 14b) aufgeteilt werden, um die Druckplatte (3) gleichzeitig mit den sechzehn Teilstrahlenbündeln (14a, 14b) abzutasten.

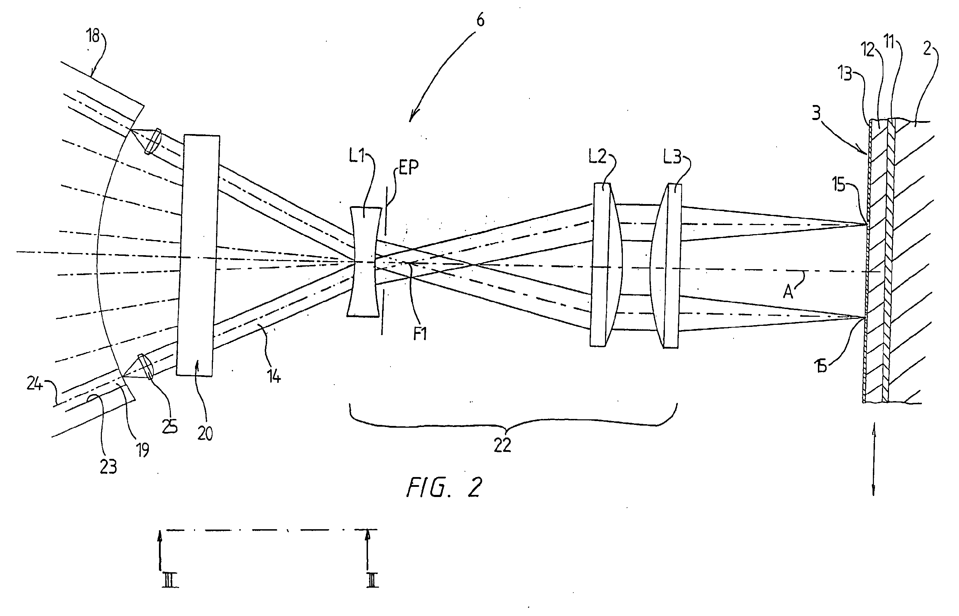

Wie am besten in Fig. 2 dargestellt, besteht die auf die Trommel (2) aufgespannte handelsübliche Flexo-Druckplatte (3) zur Lasergravur in bekannter Weise im Wesentlichen aus einer unteren Trägerschicht (11) aus Metall oder Kunststoff, vorzugsweise einer Polyesterfolie, einer auf die Oberseite der Trägerschicht (11) aufgebrachten Photopolymerschicht (12), enthaltend ungesättigte Monomere und elastomere Bindemittel, die bei einer Belichtung mit UVA-Licht zu langkettigen Polymeren vernetzt werden, sowie einer auf die Oberseite der Photopolymerschicht (12) aufgebrachten, für UV-Strahlung undurchlässigen lasersensitiven Schicht (13).

Während der Lasergravur wird die Flexo-Druckplatte (3) entsprechend einem vorgegebenen Punktraster mit den auf die lasersensitive Schicht (13) fokussierten Teilstrahlenbündeln (14a, 14b) abgetastet, wie in Fig. 2 durch zwei der Teilstrahlenbündel (14a) schematisch dargestellt. Dabei wird die lasersensitive Schicht (13) an den Auftreffpunkten (15) der Teilstrahlenbündel (14a, 14b), die beim späteren Druckvorgang Druckfarbe übertragen sollen, durch Ablation entfernt, während sie in den übrigen Bereichen erhalten bleibt. Die Ablation ist ein thermischer Prozess, bei dem die lasersensitive Schicht (13) unter Bildung punktförmiger Öffnungen bis zur Photopolymerschicht (12) verdampft und dadurch abgetragen wird. Bei einer anschließenden Bestrahlung mit UV-Licht härtet die Photopolymerschicht (12) unter den Öffnungen aus und wird im Gegensatz zu den übrigen Bereichen bei der nachfolgenden Entwicklung nicht ausgewaschen. Die Wellenlänge der von den YAG-Lasern emittierten Laserstrahlung liegt im Infrarotbereich, während das Photopolymer im UV-Bereich empfindlich ist, so dass es bei der Abtastung mit den Teilstrahlenbündeln (14a, 14b) nicht vom Laserlicht beeinflusst wird. Die Abtastung der Flexo-Druckplatte (3) erfolgt in einem vorgegebenen Punktraster, das von einem Rasterimageprozessors (nicht dargestellt) aus der auf die Druckplatte (3) zu übertragenden Schrift- oder Bildinformation in Form von digitalen Pixeldaten erzeugt wird.

Der in einer Vorschubrichtung (P) parallel zur Drehachse der Trommel (2) entlang der Druckplatte (3) bewegliche 16-Kanal-Laserbearbeitungskopf (6) besteht im Wesentlichen aus einer Halterung (18) für Fiberexits (19) der acht Faserlichtleiter (7), einem linearen AOM-Array (20) aus acht AOMs (21), in denen die acht Laserstrahlenbündel (14) nach ihrem Austritt aus den Fiberexits (19) jeweils in die beiden Teilstrahlenbündel (14a, 14b) geteilt und die letzteren unabhängig voneinander einer Intensitätsmodulation unterzogen werden, sowie einem f-θ-Optiksystem (22), mit dem die Fiberexits (19) als Multi-Spot-Array telezentrisch auf der Oberfläche der Druckplatte (3) abgebildet werden.

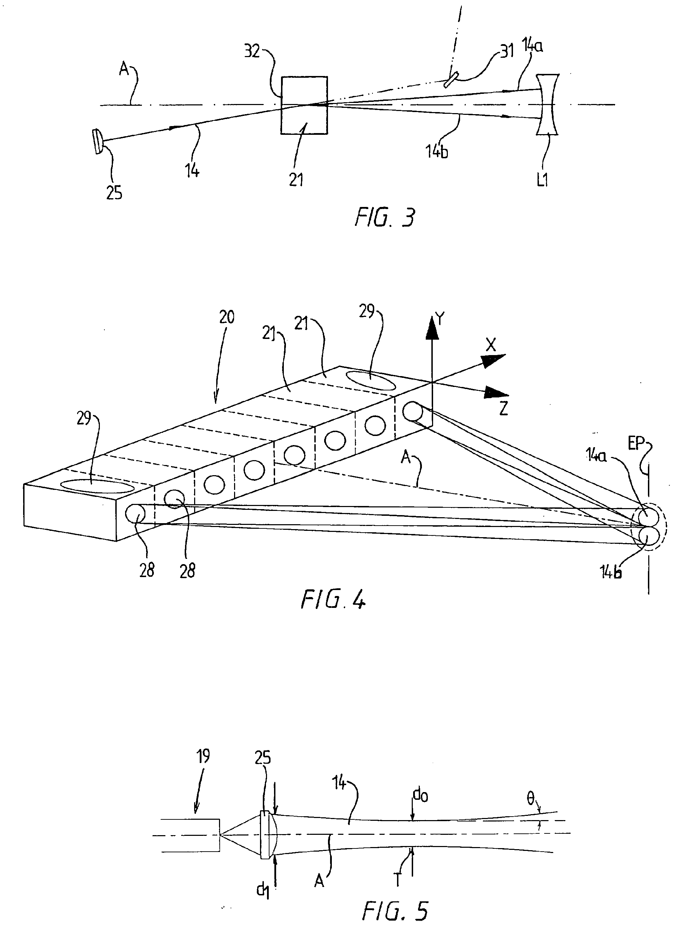

Die Fiberexits (19) sind in Aufnahmen (23) der Halterung (18) eingesetzt, die von Bohrungen oder V-förmige Nuten gebildet werden und entlang eines Kreisbogens radial angeordnet sind, so dass benachbarte Aufnahmen (23) einen Winkelabstand von etwa 10 mrad aufweisen. Der Abstand zwischen der Halterung (18) und dem Optiksystem (22) ist so gewählt, dass sich die in zwei Ebenen liegenden optischen Achsen (24) der fächerförmigen Teilstrahlenbündel (14a, 14b) in der Nähe einer Eintrittspupille (EP) des Optiksystems (22) schneiden (vgl. Fig. 2 und 4).

Wie am besten in Fig. 2 und 5 dargestellt, sind die Fiberexits (19) jeweils mit einer Mikrolinse (25) versehen, welche die aus dem Fiberexit (19) austretenden Laserstrahlen bündelt. Die Brennweite f der Mikrolinse (25) liegt je nach numerischer Apertur des Faserlichtleiters zwischen f = 3 mm und f = 7 mm. Wie in Fig. 5 dargestellt verringert sich der Strahldurchmesser des aus der Mikrolinse (25) austretenden Laserstrahlenbündels von einem Durchmesser d₁ von etwa 850 µm unmittelbar hinter der Mikrolinse (25) auf einen Taillendurchmesser d₀ von etwa 700 µm bei 1/e² und wächst dahinter mit einem Divergenzwinkel θ = 2λ/ π d₀ von etwa 1 mrad bei einem Strahldurchmesser von d₀ = 700 µm wieder an, wie durch die gebogenen Randstrahlen veranschaulicht.

Das AOM-Array (20) und die Eintrittspupille (EP) des Optiksystems (22) befinden sich jeweils in einem solchen Abstand von der Taille (T) der Laserstrahlenbündel (14), dass sowohl die AOMs (21) als auch die Eintrittspupille (EP) innerhalb des Rayleigh-Abstandes liegen, innerhalb dessen der Durchmesser der Laserstrahlenbündel (14) auf d₀ x √2 anwächst.

Wie am besten in Fig. 4 dargestellt, weist das im Bereich des Laserstrahlenbündel-Fächers angeordnete AOM-Array (20) jeweils einen AOM (21) für jedes der acht eintretenden Laserstrahlenbündel (14) auf. Die AOMs (21) entsprechen im Aufbau bekannten akustooptischen Modulatoren und umfassen einen für das Laserstrahlenbündel (14) durchlässigen Kristall (28) sowie einen piezoelektrischen Wandler (29) (nur bei einem Teil der AOMs dargestellt), der Ultraschallwellen in den Kristall (28) abgibt, wenn ein Spannungssignal am Wandler (29) angelegt wird. Bei seinem Hindurchtritt durch den Kristall (28) wird das Laserstrahlenbündel (14) an den vom Wandler (29) erzeugten Ultraschallwellen gebeugt, wobei es in Abhängigkeit von der jeweiligen Amplitude des Spannungssignals entweder als Lichtstrahl 1. Ordnung zur Eintrittspupille (EP) des Optiksystems (22) und von dort zur Flexo-Druckplatte (3) gelenkt oder durch einen Spiegel (31) (Fig. 3) als Lichtstrahl 0. Ordnung ausgeblendet wird, je nachdem ob die lasersensitive Schicht (13) der Druckplatte (3) an der entsprechenden Stelle abgetragen werden soll oder nicht. Die Amplitude der Spannungssignale wird auf der Grundlage der Pixeldaten gesteuert.

Das AOM-Array (20) ist an einer Stelle im Strahlengang der Laserstrahlenbündel (14) angeordnet, an der die Abstände der einzelnen AOMs (21) den Abständen der zugehörigen Laserstrahlenbündel (14) entsprechen und ist so ausgerichtet, dass die Laserstrahlenbündel (14) jeweils annähernd unter dem Bragg-Winkel in eine optische Eintrittsfläche (32) der AOMs (21) eintreten (Fig. 3). Um den Beugungswirkungsgrad der AOMs (21) zu verbessern und die Laserstrahlenbündel (14) möglichst ohne Vignettierung durch die AOMs (21) hindurch zu leiten, sind die Wandler (29) auf den einzelnen AOMs (21) jeweils parallel zur optischen Achse (24) des hindurchtretenden Laserstrahlenbündels (14) ausgerichtet (Fig. 4). Weiter befinden sich das AOM-Array (20) und die Eintrittspupille (EP) des Optiksystems (22) jeweils in einem solchen Abstand von der Taille (T) der Laserstrahlenbündel (14) (Fig. 5), dass sowohl die AOMs (21) als auch die Eintrittspupille (EP) innerhalb des Rayleigh-Abstandes liegen, innerhalb dessen der Durchmesser der Laserstrahlenbündel (14) auf d₀ x √2 anwächst.

Wie bereits erwähnt, wird gemäß der vorliegenden Erfindung neben der Intensitätsmodulation und dem selektiven Umschalten zwischen der 0. und 1. Ordnung in jedem AOM (21) des AOM-Arrays (20) zusätzlich eine Aufteilung des eintretenden Laserstrahlenbündels (14) in zwei oder mehr Teilstrahlenbündel (14a, 14b) vorgenommen, indem man das Licht 1. Ordnung unter verschieden großen Beugungswinkeln aus dem AOM (21) austreten lässt, wie in den Figuren 3 und 4 schematisch am Beispiel zweier Teilstrahlenbündel (14a, 14b) dargestellt. Die beiden unterschiedlichen Beugungswinkel in einer zur Zeichnungsebene der Fig. 2 senkrechten Richtung erhält man, indem man zwei Spannungssignale mit unterschiedlicher Frequenz an jedem AOM (21) anlegt, wobei der Winkelabstand zwischen den beiden erzeugten Teilstrahlenbündeln (14a, 14b) mit dem Frequenzabstand der beiden angelegten Frequenzen zunimmt. Die Zahl der möglichen Frequenzen hängt von der Bandbreite der verwendeten AOMs (21) und vom Frequenzabstand der angelegten Frequenzen ab.

Das in Fig. 2 dargestellte Optiksystem (22) besteht im Wesentlichen aus einer vor der Eintrittspupille (EP) und in deren Nähe im Strahlengang angeordneten bikonkaven Linse (L1) mit einer Brennweite f₁, sowie zwei plankonvexen Linsen (L2) und (L3) mit den Brennweiten f₂ und f₃, deren konvexe Seiten einander gegenüberliegen. Die Linsen (L1) und (L2) bilden einen "beam expander", der den Durchmesser der Teilstrahlenbündel (14a, 14b) im Verhältnis der Brennweiten f₂/f₁ aufweitet und gleichzeitig ihren Winkelabstand im Verhältnis der Brennweiten f₁/f₂ verringert. Mit der Linse (L3) werden die sechzehn Teilstrahlenbündel (14a, 14b) im Abstand f₃ telezentrisch auf der lasersensitiven Schicht (13) der Druckplatte (3) fokussiert.

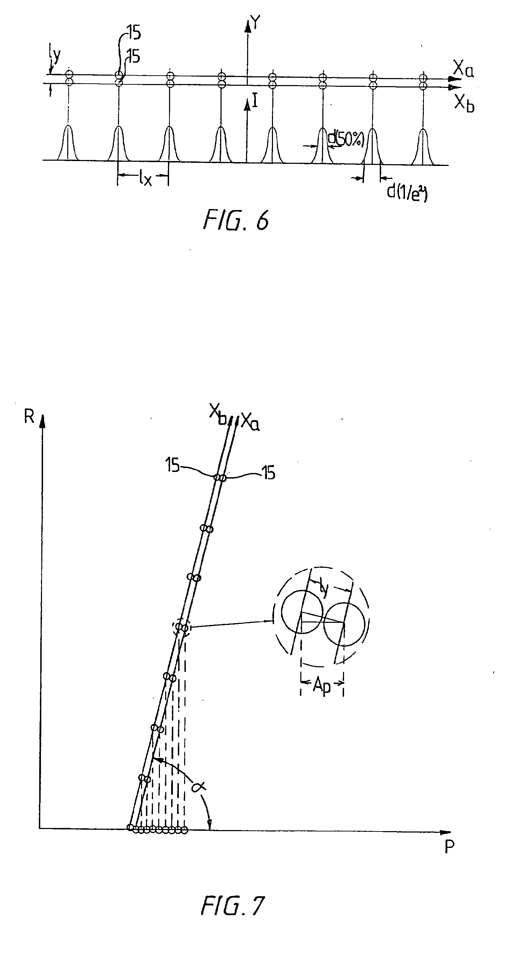

Die Brennweiten der Linsen (L1), (L2) und (L3) sind zum Beispiel so gewählt, dass sich bei einem Winkelabstand der Fiberexits (19) von 10 mrad und einem Abstand/Durchmesser-Verhältnis der Fiberexits (19) von 8 zu 1 für das in Fig. 6 dargestellte zweidimensionale Multi-Spot-Array aus 2 x 8 Auftreffpunkten (15), das ohne eine Relativbewegung zwischen Laserbearbeitungskopf (6) und der Druckplatte (3) auf der lasersensitiven Schicht (13) erzeugt wird, Spotdurchmesser d(1/e²) von etwa 32 µm und d(50%) von etwa 20 µm und zwischen benachbarten Auftreffpunkten (15) des Multi-Spot-Arrays in den von den Teilstrahlenbündeln (14a bzw. 14b) aufgespannten Ebenen, d.h. in Richtung der Achsen (Xa, Xb), Mittenabstände (lx) von etwa 160 µm ergeben. In einer zu den Achsen (Xa, Xb) senkrechten Richtung (Y-Achse) weisen die benachbarten Auftreffpunkte (15) der Teilstrahlenbündel (14a, 14b) vorzugsweise Mittenabstände (ly) von etwa 20 µm auf, so dass sie sich etwa bei 50 % der maximalen Intensität überlappen. Dadurch kann der Frequenzabstand zwischen den beiden an jedem AOM (21) angelegten Frequenzen so gering wie möglich gehalten werden, so dass diese etwa mittig innerhalb der Bandbreite des AOM (21) zu liegen kommen und ein möglichst hoher akustooptischer Wirkungsgrad gewährleistet ist.

Um Linienanschluss zu erzielen, d.h. um die Mittenabstände (lx) zwischen zwei benachbarten Auftreffpunkten (15) in axialer Richtung (P) der Trommel (2) ebenfalls so weit zu verringern, dass sich die beiden Punkte (15) bei 50 % der maximalen Intensität überlappen, wird der gesamte Laserbearbeitungskopf (6) um die Achse (A) aus der in Fig. 2 dargestellten Lage gekippt, so dass die Achsen (Xa, Xb) mit der Vorschubrichtung (P) einen Winkel α = arctan Ix/2d(50%) = arctan 8/2 = 75,96° einschließen, wie in Fig. 7 dargestellt.

Um in Vorschubrichtung (P) gleiche Abstände (Ap) zwischen benachbarten Auftreffpunkten (15) sicherzustellen, muss im Hinblick auf den Frequenzabstand zwischen den beiden an jedem AOM (21) angelegten Frequenzen ein Korrekturfaktor berücksichtigt werden. Entsprechend der vergrößerten Detailansicht aus Fig. 7 beträgt Ap = ly/sin α, so dass bei einem Winkel α von 75,96° der Frequenzabstand um etwa 3 % gegenüber dem berechneten Wert ly vergrößert werden muss, bei dem sich die benachbarten Auftreffpunkte (15) bei 50 % der maximalen Intensität überlappen.

Um sicherzustellen, dass alle sechzehn Auftreffpunkte (15) des Multi-Spot-Arrays auf einer zur Vorschubrichtung (P) parallelen Geraden liegen und nicht in Umfangsrichtung (R) der Trommel (2) versetzt auf der lasersensitiven Schicht (13) auf der Oberfläche der Flexo-Druckplatte (3) auftreffen, werden zum einen benachbarte AOMs (21) des AOM-Arrays (20) in Abhängigkeit von der Drehgeschwindigkeit der Trommel (2) zeitverzögert mit den Spannungssignalen beaufschlagt. Dabei wird die Verzögerung zwischen den Auftreffzeitpunkten zweier auf der Achse (Xa bzw. Xb) benachbarter Auftreffpunkte (15) so gewählt, dass sich die Oberfläche der Flexo-Druckplatte (3) in dieser Zeit um die Strecke lx/sin α in Trommelumfangsrichtung (R) bewegt. Zum anderen wird auch jeder einzelne AOM (21) zeitverzögert mit den beiden Spannungssignalen beaufschlagt, die zur Aufteilung des eintretenden Laserstrahlenbündels (14) in die beiden austretenden Teilstrahlenbündel (14a, 14b) dienen. Die Verzögerung wird hier so gewählt, dass sich in dieser Zeit die Oberfläche der Flexo-Druckplatte (3) um die Strecke ly/cos α in Trommelumfangsrichtung (R) bewegt.

## Patentansprüche

1. Verfahren zur Ablation von Film oder Druckplatten und insbesondere Flexo-Druckplatten (3) auf der Oberfläche einer rotierenden Trommel (2) durch Lasergravur mit einem Multi-Spot-Array, bei dem aus einer Mehrzahl von nebeneinander angeordneten Laser-Fiberexits (19), insbesondere YAG- Laser-Fiberexits, gleichzeitig eine Mehrzahl von Laserstrahlenbündeln (14) emittiert wird, bei dem die Laserstrahlenbündel (14) nach ihrem Austritt aus den Fiberexits (19) in einem AOM-Array (20) mit einer der Anzahl der Fiberexits (19) entsprechenden Anzahl von AOMs (21) jeweils in zwei oder mehr Teilstrahlenbündel (14a, 14b) aufgeteilt und die Teilstrahlenbündel (14a, 14b) unabhängig voneinander moduliert werden, bei dem die Fiberexits (19) durch ein Optiksystem (22) auf dem Film oder der Druckplatte (3) abgebildet werden, und bei dem die Fiberexits (19), das AOM-Array (20) und das Optiksystem (21) gemeinsam in axialer Richtung (P) der Trommel (2) in Bezug zu dieser bewegt werden, während der Film oder die Druckplatte (3) in Umfangsrichtung (R) der Trommel (2) mit dem Multi-Spot-Array abgetastet wird.

2. Verfahren nach Anspruch 1, **dadurch gekennzeichnet, dass** sämtliche Teilstrahlenbündel (14a, 14b) so in Richtung der Trommel (2) gelenkt werden, dass ihre Auftreffpunkte (15) nebeneinander in einer Zeile des Films oder der Druckplatte (3) zu liegen kommen und sich mit benachbarten Auftreffpunkten (15) teilweise überlappen.

3. Verfahren nach Anspruch 1 oder 2, **dadurch gekennzeichnet, dass** zur Aufteilung der Laserstrahlenbündel (14) in zwei oder mehr Teilstrahlenbündel (14a, 14b) an jedem AOM (21) Spannungssignale mit zwei oder mehr unterschiedlichen Frequenzen angelegt werden.

4. Verfahren nach Anspruch 3, **dadurch gekennzeichnet, dass** die Spannungssignale zeitversetzt am AOM (21) angelegt werden, so dass die zwei oder mehr Teilstrahlenbündel (14a, 14b) infolge der Rotation der Trommel (2) nebeneinander in einer Zeile auf dem Film oder der Druckplatte (3) auftreffen, wobei sich ihre Auftreffpunkte (15) teilweise überlappen.

5. Verfahren nach einem der Ansprüche 1 bis 4, **dadurch gekennzeichnet, dass** die Fiberexits (19) fächerförmig konvergierend ausgerichtet werden, so dass sich jeweils ein Teil der Teilstrahlenbündel (14a bzw. 14b) in der Nähe einer Eintrittspupille (EP) des Optiksystems (22) schneidet.

6. Verfahren nach Anspruch 5, **dadurch gekennzeichnet, dass** die fächerförmig ausgerichteten Teilstrahlenbündel (14a bzw. 14b) zwei oder mehr Ebenen aufspannen, wobei ihre Auftreffpunkte (15) auf dem Film oder der Druckplatte (3) in jeder Ebene jeweils auf einer Achse (Xa, Xb) liegen, die mit der axialen Richtung (P) der Trommel (2) einen Winkel α einschließt, mit arctan α = lx/2ly, wobei lx der Mittenabstand der Auftreffpunkte in Richtung der Achsen (Xa, Xb) und ly ihr Mittenabstand in einer zu den Achsen (Xa, Xb) senkrechten Richtung (Y) ist.

7. Verfahren nach einem der Ansprüche 1 bis 6, **dadurch gekennzeichnet, dass** die Fiberexits (19) durch das Optiksystem (22) nahezu telezentrisch auf dem Film oder der Druckplatte (3) abgebildet werden.

8. Verfahren nach einem der Ansprüche 5 bis 7, **dadurch gekennzeichnet, dass** die Teilstrahlenbündel (14a, 14b) hinter einer Austrittspupille des Optiksystems (22) im Wesentlichen parallel ausgerichtet und auf den Film oder die Druckplatte (3) gelenkt werden.

9. Verfahren nach einem der Ansprüche 1 bis 8, **dadurch gekennzeichnet, dass** der Durchmesser der Teilstrahlenbündel (14) im Optiksystem (22) aufgeweitet und ihr Winkelabstand verringert wird.

10. Mehrstrahl-Abtastvorrichtung zur Ablation von Film oder Druckplatten und insbesondere Flexo-Druckplatten (3) auf der Oberfläche einer rotierenden Trommel (2) durch Lasergravur mit einem Multi-Spot-Array, umfassend eine Mehrzahl von nebeneinander angeordneten Laser-Fiberexits (19), insbesondere YAG-Laser-Fiberexits, ein AOM-Array (20) mit einer der Anzahl der Fiberexits (19) entsprechenden Anzahl von AOMs (21), in denen aus den Fiberexits (19) austretende Laserstrahlenbündel (14) jeweils in zwei oder mehr Teilstrahlenbündel (14a, 14b) aufgeteilt und die Teilstrahlenbündel (14a, 14b) unabhängig voneinander moduliert werden, sowie ein Optiksystem (22) zur Abbildung der Fiberexits (19) auf dem Film oder der Druckplatte (3), wobei die Fiberexits (19), das AOM-Array (20) und das Optiksystem (22) gemeinsam in axialer Richtung (P) der Trommel (2) in Bezug zu dieser beweglich sind, während der Film oder die Druckplatte (3) in Umfangsrichtung der Trommel (2) mit dem Multi-Spot-Array abgetastet wird.

11. Mehrstrahl-Abtastvorrichtung nach Anspruch 10, **dadurch gekennzeichnet, dass** die Auftreffpunkte (15) sämtlicher Teilstrahlenbündel (14a, 14b) in einer Zeile des Film oder der Druckplatte (3) nebeneinander liegen und sich mit benachbarten Auftreffpunkten (15) teilweise überlappen.

12. Mehrstrahl-Abtastvorrichtung nach Anspruch 10 oder 11, **gekennzeichnet durch** Einrichtungen zum Anlegen von Spannungssignalen mit zwei oder mehr unterschiedlichen Frequenzen an jedem AOM (21) zur Aufteilung der Laserstrahlenbündel (14) in zwei oder mehr Teilstrahlenbündel (14a, 14b).

13. Mehrstrahl-Abtastvorrichtung nach einem der Ansprüche 10 bis 12,
**dadurch gekennzeichnet, dass** die Teilstrahlenbündel (14a bzw. 14b) zwei oder mehr Ebenen aufspannen, wobei ihre Auftreffpunkte (15) auf dem Film oder der Druckplatte (3) in jeder Ebene jeweils auf einer Achse (Xa, Xb) liegen, die mit der axialen Richtung (P) der Trommel (2) einen Winkel α einschließt, mit arctan α = lx/2ly, wobei lx der Mittenabstand der Auftreffpunkte in Richtung der Achsen (Xa, Xb) und ly ihr Mittenabstand in einer zu den Achsen (Xa, Xb) senkrechten Richtung (Y) ist.

14. Mehrstrahl-Abtastvorrichtung nach einem der Ansprüche 10 bis 13,
**dadurch gekennzeichnet, dass** die Fiberexits (19) fächerförmig konvergierend ausgerichtet sind, so dass sich jeweils ein Teil der Teilstrahlenbündel (14a bzw. 14b) in der Nähe einer Eintrittspupille (EP) des Optiksystems (22) schneidet.

15. Mehrstrahl-Abtastvorrichtung nach Anspruch 14, **dadurch gekennzeichnet, dass** die Teilstrahlenbündel (14a, 14b) hinter einer Austrittspupille des Optiksystems (22) im Wesentlichen parallel ausgerichtet sind.

16. Mehrstrahl-Abtastvorrichtung nach Anspruch 14 oder 15, **dadurch gekennzeichnet, dass** das AOM-Array (20) zwischen den Fiberexits (19) und der Eintrittspupille (EP) des Optiksystems (22) angeordnet ist.

17. Mehrstrahl-Abtastvorrichtung nach einem der Ansprüche 14 bis 16,
**dadurch gekennzeichnet, dass** die Ausrichtung von Wandlern (29) der AOMs (21) des AOM-Arrays (20) der Ausrichtung der konvergierenden Laserstrahlenbündel (14) entspricht.

18. Mehrstrahl-Abtastvorrichtung nach einem der Ansprüche 10 bis 17, **dadurch gekennzeichnet, dass** das Optiksystem (22) die Fiberexits (19) nahezu telezentrisch auf dem Film oder der Druckplatte (3) abbildet.

19. Mehrstrahl-Abtastvorrichtung nach einem der Ansprüche 10 bis 18, **dadurch gekennzeichnet, dass** das Optiksystem (22) einen Beamexpander (L1, L2) zur Aufweitung des Durchmessers der Teilstrahlenbündel (14a, 14b) unter Verringerung ihres Winkelabstandes umfasst.
